(19) Europäisches Patentamt / European Patent Office / Office européen des brevets

(11) **EP 4 336 520 A1**

(12) **EUROPEAN PATENT APPLICATION**

(43) Date of publication:
**13.03.2024 Bulletin 2024/11**

(21) Application number: **23152109.7**

(22) Date of filing: **18.01.2023**

(51) International Patent Classification (IPC):
*H01B 1/24* $^{(2006.01)}$    *C08K 7/02* $^{(2006.01)}$
*C08L 23/14* $^{(2006.01)}$    *H01B 7/28* $^{(2006.01)}$
*H01B 9/02* $^{(2006.01)}$    *H05K 9/00* $^{(2006.01)}$
*C08K 3/08* $^{(2006.01)}$    *H01L 23/552* $^{(2006.01)}$

(52) Cooperative Patent Classification (CPC):
(C-Sets available)
**H01B 1/24; C08K 7/02; C08L 23/14; H05K 9/0098;**
C08K 2003/085                                          (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.09.2022 KR 20220112820**

(71) Applicants:
• **HYUNDAI MOTOR COMPANY**
  **Seoul 06797 (KR)**
• **Kia Corporation**
  **Seocho-gu**
  **Seoul 06797 (KR)**
• **Kyungshin Cable**
  **Cheonan-si, Chungcheongnam-do 31026 (KR)**
• **Korea Kumho Petrochemical Co., Ltd.**
  **Seoul 04542 (KR)**

(72) Inventors:
• **CHOI, Seung-Woo**
  **05649 Seoul (KR)**
• **SEO, Dong-Bum**
  **34022 Daejeon (KR)**
• **OH, Kyun**
  **31463 Asan-si, Chungcheongnam-do (KR)**
• **SONG, Yu-Hyun**
  **34304 Daejeon (KR)**
• **KWON, Yang-Jin**
  **30151 Sejong-si (KR)**
• **LEE, Joo-Han**
  **35247 Daejeon (KR)**

(74) Representative: **Isarpatent**
**Patent- und Rechtsanwälte Barth**
**Charles Hassa Peckmann & Partner mbB**
**Friedrichstrasse 31**
**80801 München (DE)**

(54) **RESIN COMPOSITION FOR SHIELDING ELECTROMAGNETIC WAVES AND CABLE USING THE SAME**

(57)      An embodiment resin composition for shielding electromagnetic waves, based on a total weight of the resin composition, includes 20 to 80 wt% of thermoplastic resin, 1 to 50 wt% of a conductive filler, and 0.1 to 30 wt% of an additive. The conductive filler includes carbon fiber, carbon nanotube, carbon black, or combinations thereof

FIG. 1A

FIG. 1B

EP 4 336 520 A1

**(Cont. next page)**

(52) Cooperative Patent Classification (CPC): (Cont.)

C-Sets
**C08L 23/14, C08L 23/0815, C08K 3/04,**
**C08K 3/041;**
**C08L 23/14, C08L 23/16, C08K 3/04, C08K 3/041**

## Description

### TECHNICAL FIELD

The present disclosure relates to a resin composition for shielding electromagnetic waves and a cable using the same.

### BACKGROUND

The use of electronic components is increasing in all industrial fields, and integration is being made for high performance of the electronic components. In general, the electronic components generate electromagnetic waves. The results of research on the harmfulness to the human body due to long-term exposure to electromagnetic waves have been continuously reported, and as the problems such as device malfunction and degradation of signal quality due to electromagnetic interference have emerged, regulations for electromagnetic waves are being strengthened domestically and internationally. Accordingly, the importance of an electromagnetic wave shielding technique is increasing.

Conventionally, a metal material has been mainly used as a material for shielding electromagnetic waves. Metal is used as various materials for shielding electromagnetic waves because it has high electrical conductivity and excellent electromagnetic wave reflection properties. However, the metal has disadvantageous characteristics in terms of productivity and production cost because it is heavy and has difficulty in processing complicated shapes. In particular, in the automobile industry, the demand for materials which may replace the metal is increasing due to the issue of weight reduction for improving fuel efficiency.

In order to replace the metal material, a polymer composite material which is lighter than the metal and has excellent moldability and productivity has been proposed. In general, a conductive filler is added to the polymer composite material for shielding electromagnetic waves to give electrical conductivity to polymer. As the content of the conductive filler increases, it is possible to achieve high shielding efficiency. However, as the content of the conductive filler increases, the flowability of polymer resin may decrease, thereby lowering moldability and mechanical properties.

The matters described in the above background section are intended to help the understanding of the background of embodiments of the disclosure, and may include matters that are not already known to those skilled in the art to which this technology pertains.

### SUMMARY

The present disclosure relates to a resin composition for shielding electromagnetic waves and a cable using the same. Particular embodiments relate to a resin composition for shielding electromagnetic waves having excellent electromagnetic wave shielding performance and a cable using the same.

Embodiments of the present disclosure can solve problems in the art, and an embodiment of the present disclosure provides a resin composition for shielding electromagnetic waves having improved light-weight properties and productivity even while implementing the electromagnetic wave shielding performance and mechanical strength equivalent to a metal level, and a cable using the same.

A resin composition for shielding electromagnetic waves according to one embodiment of the present disclosure includes 20 to 80 wt% of thermoplastic resin, 1 to 50 wt% of a conductive filler which is one selected from the group consisting of carbon fiber, carbon nanotube, carbon black, and a mixture of two or more among the above components, and 0.1 to 30 wt% of an additive.

Here, the thermoplastic resin is one selected from the group consisting of thermoplastic polyurethane, thermoplastic polyester elastomer, polyamide, polyethylene, ethylene vinyl acetate copolymer, ethylene butyl acrylate copolymer, ethylene ethyl acrylate copolymer, ethylene methyl acrylate copolymer, thermoplastic crosslinked elastomer, polypropylene, polyvinyl chloride, ethylene propylene rubber, ethylene propylene diene monomer rubber, silicone rubber, fluorine-based resin, polyolefin elastomer, and a mixture of two or more among the above components.

In addition, an average length of the carbon fiber may have a range of 1 to 10 mm.

In addition, the carbon black may include a first carbon black having an average particle diameter of a range of 1 to 50 nm and a second carbon black having an average particle diameter of a range of 50 to 500 nm.

Furthermore, a weight ratio of the first carbon black and the second carbon black is 1:0.5~2.

Meanwhile, the resin composition for shielding electromagnetic waves may further contain 0.1 to 5 wt% of metal-based powder.

Here, the metal-based powder may be one selected from the group consisting of tin (Sn), copper (Cu), aluminum (Al), barium titanate ($BaTiO_3$), and a mixture of two or more among the above components.

Next, a cable for shielding electromagnetic waves according to one embodiment of the present disclosure includes a conductor, a cable sheath including the conductor, and a conductive polymer layer interposed between the conductor and the cable sheath, and including the resin composition for shielding electromagnetic waves described herein.

In addition, an average thickness of the conductive polymer layer may have a range of 0.2 to 2.0 mm.

In addition, the cable further includes a first olefin layer positioned on at least a part of a surface of the conductor, wherein the conductive polymer layer is formed on at least a part of a surface of the first olefin layer.

In addition, the cable may further include a second olefin layer positioned on at least a part of a surface of the conductive polymer layer.

Furthermore, the cable may further include a conductive tape layer interposed between the conductive polymer layer and the second olefin layer.

Here, the conductive tape may be one selected from a composite magnetic tape, an aluminum mylar tape, and a copper tape.

According to embodiments of the present disclosure, it is possible to manufacture the resin composition for shielding electromagnetic waves having excellent electromagnetic wave shielding performance by adding the conductive resin to the base resin.

In addition, it is possible to manufacture the resin composition for shielding electromagnetic waves and the cable which have improved light-weight properties and productivity even while implementing the mechanical strength by replacing the metal material.

It should be understood that the effects of embodiments of this specification are not limited to the above-described effects, and includes all effects which may be inferred from the configuration described in the detailed description or claims of this specification.

## BRIEF DESCRIPTION OF THE DRAWINGS

FIGS. 1A and 1B are a perspective view and a cross-sectional view of a cable according to one embodiment of this specification;

FIGS. 2A and 2B are a perspective view and a cross-sectional view of a cable according to another embodiment of this specification;

FIG. 3 is an electromagnetic wave shielding performance graph of cables in Examples and Comparative Examples of this specification; and

FIG. 4 is result images for a cable peeling evaluation of Examples and Comparative Examples of this specification.

## DETAILED DESCRIPTION OF ILLUSTRATIVE EMBODIMENTS

Hereinafter, embodiments of this specification will be described with reference to the accompanying drawings. However, the description of this specification may be implemented in various different forms, and thus is not limited to the embodiments described herein. In addition, in order to clearly describe embodiments of this specification, portions irrelevant to the description are omitted, and similar reference numerals are denoted to similar portions throughout the specification.

Throughout the specification, when a certain portion is described as being "connected" with another portion, this includes not only a case of being "directly connected" but also a case of being "indirectly connected" with another member interposed therebetween. In addition, when a certain portion is described as "including" a certain component, this means that other components may be further included rather than excluding other components, unless otherwise stated.

In this specification, when a range of numerical values is described, the values have the precision of the significant figures provided in accordance with the standard rules in chemistry for significant figures, unless the specific range thereof is otherwise stated. For example, 10 includes a range of 5.0 to 14.9 and the number 10.0 includes a range of 9.50 to 10.49.

Hereinafter, embodiments of this specification will be described in detail with reference to the accompanying drawings.

Resin composition for shielding electromagnetic waves

Conventionally, metal such as copper or aluminum is used as a material for shielding electromagnetic waves.

The metal has excellent electromagnetic wave shielding performance but there is a limit to implementing light-weight properties due to metal characteristics. Accordingly, embodiments of the present disclosure provide a resin composition for shielding electromagnetic waves having excellent light-weight properties as well as excellent electromagnetic wave shielding performance by replacing a metal material.

The resin composition for shielding electromagnetic waves according to one embodiment of the present disclosure may include 20 to 80 wt% of thermoplastic resin, 1 to 50 wt% of conductive filler which is one selected from the group consisting of carbon fiber, carbon nanotube, carbon black, and mixtures of two or more among the above components, and 0.1 to 30 wt% of an additive.

The resin composition for shielding electromagnetic waves may contain 20 to 80 wt% of thermoplastic resin. For example, the content of the thermoplastic resin may have 20 wt%, 21 wt%, 22 wt%, 23 wt%, 24 wt%, 25 wt%, 26 wt%, 27 wt%, 28 wt%, 29 wt%, 30 wt%, 31 wt%, 32 wt%, 33 wt%, 34 wt%, 35 wt%, 36 wt%, 37 wt%, 38 wt%, 39 wt%, 40 wt%, 41 wt%, 42 wt%, 43 wt%, 44 wt%, 45 wt%, 46 wt%, 47 wt%, 48 wt%, 49 wt%, 50 wt%, 51 wt%, 52 wt%, 53 wt%, 54 wt%, 55 wt%, 56 wt%, 57 wt%, 58 wt%, 59 wt%, 60 wt%, 61 wt%, 62 wt%, 63 wt%, 64 wt%, 65 wt%, 66 wt%, 67 wt%, 68 wt%, 69 wt%, 70 wt%, 71 wt%, 72wt%, 73 wt%, 74 wt%, 75 wt%, 76 wt%, 77 wt%, 78 wt%, 79 wt%, 80 wt%, or a range between two of these values. When the content of the thermoplastic resin is out of the above range, the electromagnetic wave shielding performance may be lowered or moldability may be poor.

The thermoplastic resin may be one selected from the group consisting of thermoplastic polyurethane, thermoplastic polyester elastomer, polyamide, polyethylene, ethylene vinyl acetate copolymer, ethylene butyl acrylate copolymer, ethylene ethyl acrylate copolymer, ethylene methyl acrylate copolymer, thermoplastic crosslinked elastomer, polypropylene, polyvinyl chloride, ethylene propylene rubber, ethylene propylene diene monomer rubber, silicone rubber, fluorine-based resin, polyolefin elastomer, and mixtures of two or more among the above components.

As an example, the thermoplastic resin may be crosslinked by one method selected from electron beam crosslinking, hydro crosslinking, and chemical crosslinking as necessary but embodiments of the present disclosure are not limited thereto. For example, the thermoplastic resin may undergo a crosslinking reaction by a crosslinking aid or a crosslinking agent, thereby improving the mechanical strength or heat resistance of the thermoplastic resin.

Next, the resin composition for shielding electromagnetic waves may contain a range of 1 to 50 wt% of the conductive filler. For example, the content of the conductive filler may have 1 wt%, 2 wt%, 3 wt%, 4 wt%, 5 wt%, 6 wt%, 7 wt%, 8 wt%, 9 wt%, 10 wt%, 11 wt%, 12 wt%, 13 wt%, 14 wt%, 15 wt%, 16 wt%, 17 wt%, 18 wt%, 19 wt%, 20 wt%, 21 wt%, 22 wt%, 23 wt%, 24 wt%, 25 wt%, 26 wt%, 27 wt%, 28 wt%, 29 wt%, 30 wt%, 31 wt%, 32 wt%, 33 wt%, 34 wt%, 35 wt%, 36 wt%, 37 wt%, 38 wt%, 39 wt%, 40 wt%, 41 wt%, 42 wt%, 43 wt%, 44 wt%, 45 wt%, 46 wt%, 47 wt%, 48 wt%, 49 wt%, 50 wt%, or a range between two of these values. When the content of the conductive filler is out of the above range, electromagnetic wave shielding performance may be lowered or moldability may be poor.

The conductive filler may be added to the thermoplastic resin to give electrical conductivity to the conductive polymer. When an insulating material is used as the thermoplastic resin, the electrical conductivity of the conductive polymer may be determined by the conductive filler. The conductive filler may be dispersed in resin matrices and interconnected to form a continuous three-dimensional network structure, and as a result, a surface resistance may be decreased, thereby implementing excellent electrical conductivity and electromagnetic wave shielding effect.

The conductive filler may be one selected from the group consisting of carbon fiber, carbon nanotube, carbon black, and mixtures of two or more among the above components.

The carbon fiber may be a pan-based or pitch-based carbon fiber, but the type thereof is not limited thereto as long as it has excellent kneading properties with the thermoplastic resin. An average length of the carbon fiber may be in a range of 1 to 10 mm, for example, 1 mm, 2 mm, 3 mm, 4 mm, 5 mm, 6 mm, 7 mm, 8 mm, 9 mm, 10 mm, or a range between two of these values. When the average length of the carbon fiber is out of the above range, dispersibility may be lowered or mechanical strength may be lowered.

The carbon nanotube may be one selected from the group consisting of a single wall carbon nanotube, a double wall carbon nanotube, a multi wall carbon nanotube, a cup-stacked carbon nanofiber with a plurality of truncated graphene stacked, and a mixture of two or more among the above components but embodiments of the present disclosure are not limited thereto.

As a non-limiting example, the carbon nanotube may be included by being manufactured in a master batch type. When the carbon nanotube is manufactured in the master batch, the control of the carbon nanotube having a low bulk density may be easy, and excellent properties may be exhibited even with a small amount. In addition, it is possible to improve dispersibility in the thermoplastic resin, thereby improving electrical conductivity and electromagnetic wave shielding performance. The master batch may be manufactured in a spheric type, a pellet type, a sheet type, or the like, but may be manufactured without limitation in its shape as long as it can improve the dispersibility of the carbon nanotube by being mixed with the thermoplastic resin. As a non-limiting example, the carbon nanotube may be used by being mixed with graphene but embodiments of the present disclosure are not limited thereto.

The carbon black has lower conductivity than that of the carbon nanotube but may have excellent dispersibility, thereby increasing flowability. The carbon black is formed in a form which is aggregated by collecting small particles, and thus has various structures. The shielding performance and moldability of the resin composition for shielding electromagnetic waves may be adjusted according to a particle diameter and aggregate structure of the carbon black.

For example, the carbon black may include a first carbon black having an average particle diameter of a range of 1 to 50 nm and a second carbon black having an average particle diameter of a range of 50 to 500 nm. The average particle diameter of the first carbon black may have, for example, 1 nm, 5 nm, 10 nm, 15 nm, 20 nm, 25 nm, 30 nm, 35 nm, 40 nm, 45 nm, 50 nm, or a range between two of these values. The average particle diameter of the second carbon black may have, for example, 50 nm, 75 nm, 100 nm, 125 nm, 150 nm, 175 nm, 200 nm, 225 nm, 250 nm, 275 nm, 300 nm, 325 nm, 350 nm, 375 nm, 400 nm, 425 nm, 450 nm, 475 nm, 500 nm, or a range between two of these values. When the carbon black having a small average particle diameter is used, the electrical conductivity and the shielding effect are improved, but an elongation rate may be lowered due to poor dispersibility. When the first carbon black and the second carbon black having different average particle diameters are used by being mixed, the above trade-off relationship can be eliminated.

In one example, a weight ratio of the first carbon black and the second carbon black may be 1:0.5~2, respectively. For example, the content of the second carbon black may have 0.5 parts by weight, 0.6 parts by weight, 0.7 parts by weight, 0.8 parts by weight, 0.9 parts by weight, 1 part by weight, 1.1 parts by weight, 1.2 parts by weight, 1.3 parts by weight, 1.4 parts by weight, 1.5 parts by weight, 1.6 parts by weight, 1.7 parts by weight, 1.8 parts by weight, 1.9 parts by weight, 2 parts by weight, or a range between two of these values based on 1 part by weight of the first carbon black.

Each component of the conductive filler may be used alone, or two or more components may be used by being mixed. For example, the carbon fiber and the carbon nanotube, the carbon fiber and the carbon black, the carbon nanotube and the carbon black, and the carbon fiber, the carbon nanotube, and the carbon black may be used simultaneously.

When the carbon fiber and the carbon nanotube are used, the weight ratio of the carbon fiber and the carbon nanotube may be 5~30:1, respectively. For example, the carbon fiber which has 5 parts by weight, 6 parts by weight, 7 parts by weight, 8 parts by weight, 9 parts by weight, 10 parts by weight, 11 parts by weight, 12 parts by weight, 13 parts by weight, 14 parts by weight, 15 parts by weight, 16 parts by weight, 17 parts by weight, 18 parts by weight, 19 parts by weight, 20 parts by weight, 21 parts by weight, 22 parts by weight, 23 parts by weight, 24 parts by weight, 25 parts by weight, 26 parts by weight; 27 parts by weight, 28 parts by weight, 29 parts by weight, 30 parts by weight, or a range between two of these values based on 1 part by weight of the carbon nanotube may be used, but embodiments of the present disclosure are not limited thereto.

When the carbon fiber and the carbon black are used, the weight ratio of the carbon fiber and the carbon black may be 1~3:1, respectively. For example, the carbon fiber which has 1 part by weight, 1.5 parts by weight, 2 parts by weight, 2.5 parts by weight, 3 parts by weight, or a range between two of these values based on 1 part by weight of carbon black may be used, but embodiments of the present disclosure are not limited thereto.

When the carbon nanotube and the carbon black are used, the weight ratio of the carbon nanotube and the carbon black may be 1:3~15, respectively. For example, the carbon black which has 3 parts by weight, 4 parts by weight, 5 parts by weight, 6 parts by weight, 7 parts by weight, 8 parts by weight, 9 parts by weight, 10 parts by weight, 11 parts by weight, 12 parts by weight, 13 parts by weight, 14 parts by weight, 15 parts by weight, or a range between two of these values based on 1 part by weight of the carbon nanotube may be used, but embodiments of the present disclosure are not limited thereto.

When the carbon fiber, the carbon nanotube, and the carbon black are used simultaneously, the weight ratio of the carbon fiber, the carbon nanotube, and the carbon black may be 5~3o:1:3~15, respectively, but embodiments of the present disclosure are not limited thereto.

When two or more components of the carbon fiber, the carbon nanotube, and the carbon black are used by being mixed, it is possible to improve the trade-off relationship between electrical conductivity, shielding effect, mechanical properties, and workability, but when the content ratio is out of the range of the above-described content ratio, the advantage of mixing use may not be exhibited.

The resin composition for shielding electromagnetic waves may include 0.1 to 30 wt% of an additive. For example, the content of the additive may have 0.1 wt%, 0.2 wt%, 0.3 wt%, 0.4 wt%, 0.5 wt%, 0.6 wt%, 0.7 wt%, 0.8 wt%, 0.9 wt%, 1 wt%, 2 wt%, 3 wt%, 4 wt%, 5 wt%, 6 wt%, 7 wt%, 8 wt%, 9 wt%, 10 wt%, 11 wt%, 12 wt%, 13 wt%, 14 wt%, 15 wt%, 16 wt%, 17 wt%, 18 wt%, 19 wt%, 20 wt%, 21 wt%, 22 wt%, 23 wt%, 24 wt%, 25 wt%, 26 wt%, 27 wt%, 28 wt%, 29 wt%, 30 wt%, or a range between two of these values.

The additive may be one selected from the group consisting of antioxidant, crosslinking aid, lubricant, stabilizer, and a mixture of two or more among the above components but embodiments of the present disclosure are not limited thereto. As for the type of the additive, a commonly used additive may be used depending on the type of the thermoplastic resin.

When the antioxidant is used among the additives, the antioxidant which has 0.1 to 10 parts by weight, for example, a range between 0.1 parts by weight, 0.5 parts by weight, 1 part by weight, 1.5 parts by weight, 2 parts by weight, 2.5 parts by weight, 3 parts by weight, 3.5 parts by weight, 4 parts by weight, 4.5 parts by weight, 5 parts by weight, 5.5 parts by weight, 6 parts by weight, 6.5 parts by weight, 7 parts by weight, 7.5 parts by weight, 8 parts by weight, 8.5 parts by weight, 9 parts by weight, 9.5 parts by weight, and 10 parts by weight based on 100 parts by weight of the resin composition may be used.

When the crosslinking aid is used among the additives, the crosslinking aid which has 0.1 to 10 parts by weight, for example, a range between 0.1 parts by weight, 0.5 parts by weight, 1 part by weight, 1.5 parts by weight, 2 parts by weight, 2.5 parts by weight, 3 parts by weight, 3.5 parts by weight, 4 parts by weight, 4.5 parts by weight, 5 parts by weight, 5.5 parts by weight, 6 parts by weight, 6.5 parts by weight, 7 parts by weight, 7.5 parts by weight, 8 parts by weight, 8.5 parts by weight, 9 parts by weight, 9.5 parts by weight, and 10 parts by weight based on 100 parts by weight of the resin composition may be used.

When the lubricant is used among the additives, the lubricant which has 0.1 to 5 parts by weight, for example, a range between 0.1 parts by weight, 0.5 parts by weight, 1 part by weight, 1.5 parts by weight, 2 parts by weight, 2.5 parts by weight, 3 parts by weight, 3.5 parts by weight, 4 parts by weight, 4.5 parts by weight, and 5 parts by weight based on 100 parts by weight of the resin composition may be used.

When the stabilizer is used among the additives, the stabilizer which has 0.1 to 5 parts by weight, for example, a range between 0.1 parts by weight, 0.5 parts by weight, 1 part by weight, 1.5 parts by weight, 2 parts by weight, 2.5 parts by weight, 3 parts by weight, 3.5 parts by weight, 4 parts by weight, 4.5 parts by weight, and 5 parts by weight based on 100 parts by weight of the resin composition may be used.

When the content of each additive is out of the above range, the properties of a product made of the resin composition for shielding electromagnetic waves may be lowered, or it may be difficult to give the effect due to the addition.

As an example, the resin composition for shielding electromagnetic waves may further include 0.1 to 5 wt% of a metallic powder. For example, the content of the metallic powder may have 0.1 wt%, 0.2 wt%, 0.3 wt%, 0.4 wt%, 0.5 wt%, 0.6 wt%, 0.7 wt%, 0.8 wt%, 0.9 wt%, 1 wt%, 2 wt%, 3 wt%, 4 wt%, 5 wt%, or a range between two of these values. When the content of the metallic powder is out of the above range, electromagnetic wave shielding performance may be lowered or an agglomeration phenomenon between the powders may occur, thereby lowering the physical properties.

The metallic powder may be one selected from the group consisting of tin (Sn), copper (Cu), aluminum (Al), barium titanate (BaTiO$_3$), and a mixture of two or more among the above components but embodiments of the present disclosure are not limited thereto.

Cable for shielding electromagnetic waves

The cable for shielding electromagnetic waves according to embodiments of the present disclosure includes a conductor 10 and a cable sheath and has a conductive polymer layer 30 containing the above-described resin composition for shielding electromagnetic waves interposed between the conductor 10 and the cable sheath, so that it is possible to improve light-weight properties and productivity as well as electromagnetic wave shielding performance compared to the conventional polymer and to contribute to light-weight properties and productivity due to the improvement in these physical properties when the cable is applied to the vehicle.

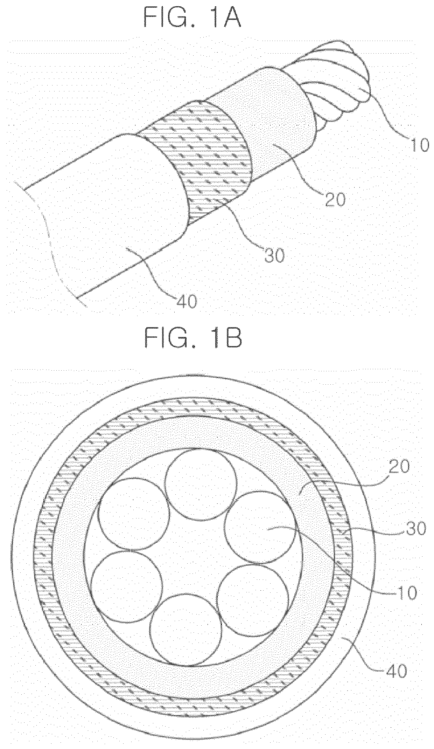

As a specific example, referring to FIGS. 1A and 1B, the cable for shielding electromagnetic waves according to embodiments of the present disclosure may include the conductor 10, a first olefin layer 20 positioned on at least a part of a surface of the conductor 10, the conductive polymer layer 30 formed on at least a part of the surface of the first olefin layer 20 and containing the above-described resin composition, and a second olefin layer 40 positioned on at least a part of a surface of the conductive polymer layer 30 and constituting a sheath.

The conductor 10 may be a conductive material, for example, copper, tin-plated copper, nickel-plated copper, silver-plated copper, an alloy of copper and tin, an alloy of copper and magnesium, aluminum, copper-coated aluminum, an aluminum alloy, a copper-coated aluminum and magnesium alloy, or copper-coated iron, but embodiments of the present disclosure are not limited thereto. The conductor 10 may be a single wire or a stranded wire in which several wires are twisted.

The first olefin layer 20 may be formed on at least a part of the surface of the conductor 10. The first olefin layer 20 may be formed in a form which surrounds the conductor 10 to shield electromagnetic waves generated from the conductor 10. The first olefin layer 20 may be, for example, one selected from the group consisting of polyvinyl chloride, polyethylene, polyamide, polytetrafluoroethylene, fluorinated ethylene propylene, ethylene tetrafluoroethylene, polypropylene, polyvinylidene fluoride, perfluoro alkoxy copolymer, thermoplastic polyurethane, thermoplastic polyether polyurethane, thermoplastic polyether ester elastomer, thermoplastic polyether elastomer, thermoplastic polystyrene block copolymer, thermoplastic polyamide elastomer, silicone rubber, and a mixture of two or more among the above components, but embodiments of the present disclosure are not limited thereto.

In addition, the conductive polymer layer 30 may be made of the above-described resin composition for shielding electromagnetic waves.

The conductive polymer layer 30 may be made of the resin composition for shielding electromagnetic waves manufactured by containing the conductive filler and the additive in the thermoplastic resin, which is the base resin, to have excellent electrical conductivity and electromagnetic wave shielding performance. The conductive polymer layer 30 may shield electromagnetic waves which are not shielded by the first olefin layer 20. The types of the thermoplastic resin, conductive filler, and additive forming the conductive polymer layer 30, the physical properties of each component, and the effects that can be implemented therefrom are as described above.

For example, an average thickness of the conductive polymer layer 30 may have the range of 0.2 to 2.0 mm. For example, the average thickness of the polymer layer 30 may be 0.2 mm, 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2.0 mm, or a range between two of these values. When the average thickness of the conductive polymer layer 30 is out of the above range, electromagnetic wave shielding performance may be lowered or the connection with a cable connector may be poor.

The elongation rate of the conductive polymer layer 30 may be 50% or more, for example, 50% or more, 60% or more, 70% or more, 80% or more, 90% or more, 100% or more, 110% or more, 120% or more, 130% or more, 140% or more, 150% or more, 200% or more, 250% or more, 300% or more, 350% or more, 400% or more, but embodiments of the present disclosure are not limited thereto. When the cable is manufactured with a resin composition in which the elongation rate of the conductive polymer layer 30 is smaller than 30%, cracks may occur in an extrusion process, thereby causing poor processability, and even when the cable is extruded, the physical properties of the cable may be unsatisfactory.

The second olefin layer 40 may be formed on at least a part of the surface of the conductive polymer layer 30. The second olefin layer 40 may be formed in the form which surrounds the conductive polymer layer to cover the conductive polymer layer 30. The type of the second olefin layer 40 may be the same as that used for the first olefin layer 20, but embodiments of the present disclosure are not limited thereto.

Each of resin matrices of the first olefin layer 20, the conductive polymer layer 30, and the second olefin layer 40 constituting the cable for shielding electromagnetic waves may be the resin matrix which is independently crosslinked or non-crosslinked. When a matrix in which the base resin is crosslinked is used, the olefin composition or the resin composition may contain the crosslinking aid or the crosslinking agent in order to perform the electron beam crosslinking, the hydro crosslinking, or the chemical crosslinking.

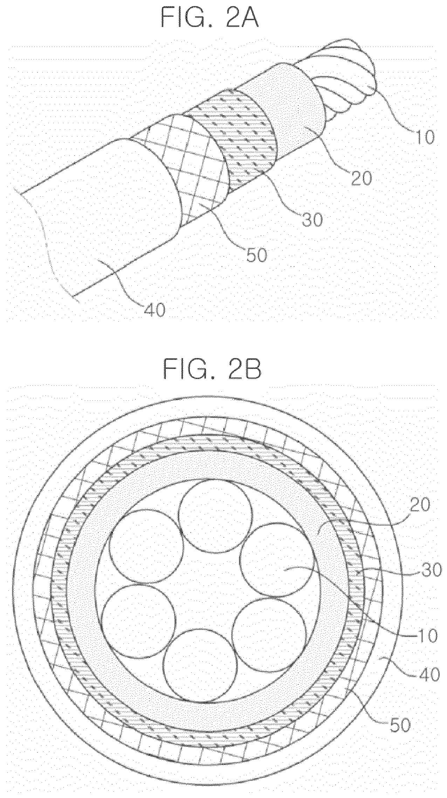

As another example, the cable for shielding electromagnetic waves may further include a conductive tape layer 50 between the conductive polymer layer 30 and the second olefin layer 40. An example thereof is shown in FIGS. 2A and 2B. The conductive tape layer 50 can improve electromagnetic wave shielding performance while preventing peeling between the conductive polymer layer 30 and the second olefin layer 40. Specifically, a coupling force with the second olefin layer 40, which may be lowered due to the flowability of the base resin in the conductive polymer layer, can be improved by the conductive tape layer 50, and at the same time, electromagnetic wave shielding performance can also be improved. The conductive tape may be, for example, one selected from a composite magnetic tape, an aluminum mylar tape, and a copper tape, but embodiments of the present disclosure are not limited thereto.

Hereinafter, embodiments of this specification will be described in more detail. However, the following experimental results describe only representative experimental results among the above embodiments, and the scope and content of this specification may not be construed as reduced or limited by the embodiments and the like. The effects of each of various embodiments of this specification which are not explicitly presented below will be specifically described in the corresponding section.

Examples 1 to 5 and Comparative Examples 1 to 4

The base resin was added to the raw material inlet of the twin-screw extruder (L/D=44, Φ=32 mm) heated at 250°C, and the additives such as a lubricant, stabilizer, and crosslinking aid were added. The resin composition for shielding electromagnetic waves was manufactured by adding and then thermally melting and kneading carbon black (CB), carbon fiber having a length of 6 mm, carbon nanotube (CNT), and metal powder through the side feeder. The manufactured resin composition was dried in the hot air dryer at 90°C for 4 hours.

Detailed types and contents of each component are shown in Table 1.

**Table** 1

| Items | | Comparative Manufacturing Example (wt%) | | | | Manufacturing Example (wt%) | | | | |
|---|---|---|---|---|---|---|---|---|---|---|
| | | 1 | 2 | 3 | 4 | 1 | 2 | 3 | 4 | 5 |
| Thermo plastic resin | POE | 50 | 40 | 10 | 40 | 40 | 40 | 40 | 40 | 40 |

(continued)

| Items | | Comparative Manufacturing Example (wt%) | | | | Manufacturing Example (wt%) | | | | |
|---|---|---|---|---|---|---|---|---|---|---|
| | | 1 | 2 | 3 | 4 | 1 | 2 | 3 | 4 | 5 |
| Thermo plastic resin | LLDPE | - | 10 | - | 10 | 10 | 10 | 10 | 10 | 10 |
| Thermo plastic resin | EPDM | - | - | 40 | - | - | - | - | - | - |
| Carbon black | First CB | 15 | 15 | 15 | - | 5 | 5 | 5 | 5 | 5 |
| Carbon black | Second CB | - | - | - | 15 | 10 | 10 | 10 | 10 | 10 |
| Carbon fiber | | 28 | 28 | 28 | 28 | 28 | 28 | 28 | 28 | 28 |
| Carbon nanotube (CNT) | | 2 | 2 | 2 | 2 | 2 | 2 | 2 | 4 | - |
| Metal powder | BaTiO$_3$ | - | - | - | - | 3 | - | - | - | - |
| Metal powder | Cu powder | - | - | - | - | - | 3 | - | 3 | 3 |
| Metal powder | Sn powder | - | - | - | - | - | - | 3 | - | - |
| CNT+ graphene | | - | - | - | - | - | - | - | - | 2 |
| Lubricant | Paraffin wax | 2 | 2 | 2 | 2 | 2 | 2 | 2 | 2 | 2 |
| Lubricant | PPA | 0.5 | 0.5 | 0.5 | 0.5 | 0.5 | 0.5 | 0.5 | 0.5 | 0.5 |
| Stabilizer | Primary stabilizer | 0.5 | 0.5 | 0.5 | 0.5 | 0.5 | 0.5 | 0.5 | 0.5 | 0.5 |
| Stabilizer | Metal stabilizer | 0.5 | 0.5 | 0.5 | 0.5 | 0.5 | 0.5 | 0.5 | 0.5 | 0.5 |
| Crosslinking aid | TMPTM A | 1.5 | 1.5 | 1.5 | 1.5 | 1.5 | 1.5 | 1.5 | 1.5 | 1.5 |

-POE: Polyolefin elastomer
-LLDPE: Linear low density polyethylene
-EPDM: Ethylene propylene rubber
-PPA: Polyphthalamide
-TMPTMA: Trimethylolpropane trimethacrylate

Experimental Example 1: Evaluation of the physical properties of the resin composition for shielding electromagnetic waves

The evaluation of the physical properties of the resin composition for shielding electromagnetic waves manufactured according to Manufacturing Examples and Comparative Manufacturing Examples was performed and the results thereof are shown in Table 2 below.

Samples of the resin composition for shielding electromagnetic waves manufactured for evaluation were manufactured according to the standard (OD: Φ48.2 mm, ID: 6.1 mm) using the 150t injection machine at the injection temperature of 285°C.

Each analysis method is as follows.

1) Evaluation for shielding characteristics

In accordance with ASTM ES7, the received power P1 was measured by positioning the reference sample on the measurement jig, and the received power P2 was measured by positioning the samples (Load) manufactured according to Examples and Comparative Examples. The shielding efficiency was calculated by substituting the measured value into the following equation.

Equation

$$a_{\mathrm{meas}} = 10 \log_{10}\left(\frac{P_1}{P_2}\right) = -20 \log_{10}(S_{21})$$

2) Evaluation for volume resistance

In accordance with ASTM D991, the volume resistance was measured at room temperature.

3) Evaluation for tensile strength and elongation rate

In accordance with ASTM D638, the tensile strength and the elongation rate were measured at room temperature at a rate of 25 mm/min.

4) Evaluation for hardness

In accordance with ASTM D2240, the hardness was measured based on Shore D.

5) Evaluation for specific gravity

In accordance with ASTM D1505, the specific gravity was measured at room temperature.

**Table 2**

| Items | Comparative Manufacturing Example | | | | Manufacturing Example | | | | |
|---|---|---|---|---|---|---|---|---|---|
| Items | 1 | 2 | 3 | 4 | 1 | 2 | 3 | 4 | 5 |
| Shielding effect (dB @ 3MHz) | 43.4 | 42.4 | 38 | 36.6 | 40.1 | 44.8 | 42.3 | 47.5 | 40 |
| Shielding effect (dB @ 3GHz) | 61.5 | 58.9 | 49 | 46.3 | 53.4 | 63.3 | 58.1 | 67.7 | 52.5 |
| Volume resistance ($\Omega$·cm) | 0.07 | 0.98 | 0.21 | 0.23 | 0.14 | 0.06 | 0.07 | 0.04 | 0.11 |
| Tensile strength (kgf/mm$^2$) | 0.78 | 0.83 | 0.19 | 0.58 | 0.63 | 0.72 | 0.81 | 0.75 | 0.74 |
| Elongation rate (%) | 65.4 | 125 | 35 | 461 | 348 | 216 | 225 | 125 | 214 |
| Hardness (Shore D) | 39 | 41.5 | 23 | 41 | 41.6 | 42.8 | 43.1 | 43.4 | 42.9 |
| Specific gravity | 1.10 | 1.15 | 1.09 | 1.13 | 1.15 | 1.17 | 1.17 | 1.18 | 1.17 |

Referring to the results in Table 2, it can be confirmed that Manufacturing Examples 1 to 5 and Comparative Manufacturing Examples 1 and 2 satisfy 40dB@3MHz, which is the reference value of the shielding cable for a vehicle in shielding performance.

However, in Comparative Manufacturing Examples 1 and 2, there was a problem in that the shielding performance was sufficient but each had an insufficient elongation rate or a high volume resistance. Since it can be said that the volume resistance is relatively high when the volume resistance is 0.3Ω·cm or more, it can be said that the volume resistance is high in Comparative Manufacturing Example 2.

In addition, it was found that in Comparative Manufacturing Examples 3 and 4, the shielding performance was insufficient.

In particular, in Manufacturing Example 4, it could be seen that the shielding performance was the best and it was found that the excellent physical properties of 100% or more was secured because the elongation rate was 125%, and in Manufacturing Examples 1 to 3 and 5, it could be seen that the excellent elongation rate was exhibited.

Experimental Example 2: Evaluation for electromagnetic wave shielding performance of cable according to presence or absence of conductive tape

The electromagnetic wave shielding performance of the cable according to the presence or absence of the conductive tape was evaluated. For the experiment, a cable sequentially including a copper conductor, a first polyethylene layer, a conductive polymer in Manufacturing Example 4 having the best shielding performance among Examples, an aluminum mylar tape, and a second polyethylene layer was manufactured as Example 1. A cable including copper, which is the conventional metal shielding material, was set to Comparative Example 1. A cable manufactured in the same manner as in Example 1 except that the conductive polymer was replaced with the aluminum mylar tape was set to Comparative Example 2.

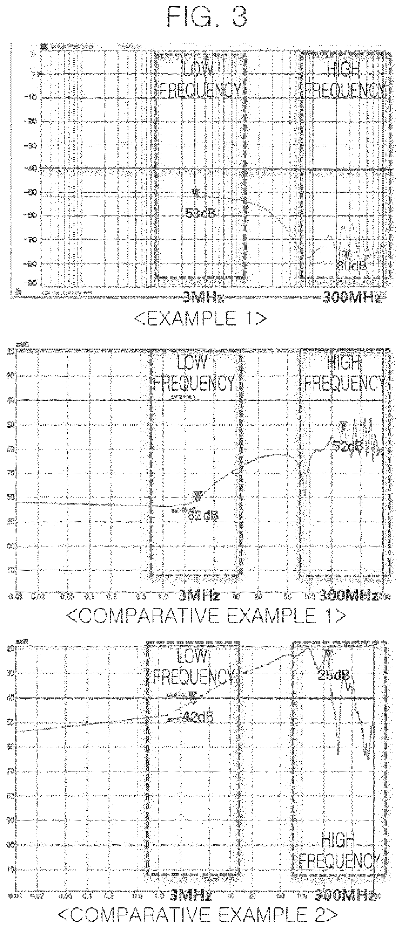

The shielding performance of each of the cables in Examples 1 and Comparative Examples 1 and 2 was measured in low and high frequency regions, and the results thereof are shown in FIG. 3.

Referring to FIG. 3, it can be confirmed that the electromagnetic wave shielding performance of the cable in Example 1 was improved from the low frequency region toward the high frequency region. In Comparative Example 1, it can be confirmed that the shielding performance is excellent in the low frequency region but the shielding performance is lowered in the high frequency region. In Comparative Example 2, the aluminum mylar tape was included alone and the shielding performance tended to be lowered in the high frequency region.

Accordingly, it can be confirmed that the cable in Example 1 exhibits more improved electromagnetic wave shielding performance in the high frequency region due to the rising effect of the conductive polymer layer and the conductive tape, and it can be confirmed that it is advantageous in the high speed communication (high frequency) region.

Experimental Example 3: Evaluation for peeling improvement of cable according to presence or absence of conductive tape

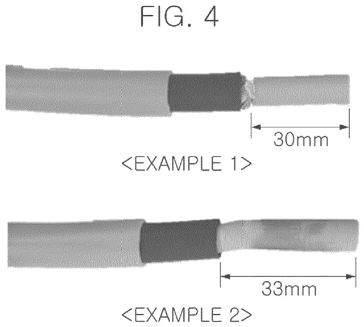

In order to evaluate the effect of improving the peeling of the cable according to the presence or absence of the conductive tape, the evaluation was conducted by manufacturing the cable in Example 1, which is a cable including the conductive polymer layer and the aluminum mylar tape, and the cable in Example 2, which is a cable excluding the tape, and the results thereof are shown in FIG. 4.

Referring to FIG. 4, in Example 1, the cable satisfies the standard peeling length of 30 mm, but in Example 2, the result value increased by 3 mm compared to Example 1 is shown.

Accordingly, it was confirmed that the peeling performance was further improved by the conductive tape.

Experimental Example 4: Evaluation for light-weight properties of cable according to shielding material

In order to evaluate the light-weight properties according to the shielding material, the evaluation for the physical properties of the cable in Comparative Example 1 including the copper shielding material, which is the conventional shielding material, and the cable in Example 1 including the conductive polymer layer was analyzed, and the results thereof are shown in Table 3.

Table 3

| Items | | Comparative Example 1 | Example 1 | |
|---|---|---|---|---|
| Specific gravity | | 8.89 | 1.2 | |
| Thickness of shielding layer (mm) | | 0.45 | 0.75 | |
| Completed outer diameter (mm) | | 10.3 | 10.9 (Increase by 5.8%) | |
| Weight (kg/km) | Shielding material | 100% | | 50% (Compared to Comparative Example 1) |
| | Total weight | 100% | | 10% (Compared to Comparative Example 1) |

Referring to Table 3, in Example 1, it can be confirmed that the specific gravity is low and the thickness of the shielding layer of 0.75 is greater than that in Comparative Example 1, whereas in the weight, the shielding material itself is decreased by 50%, and the entire cable is decreased by 10%, so that it is possible to implement the excellent light-weight effect. In the case of a vehicle to which the cable in Example 1 is applied, it can be expected that fuel efficiency will be improved due to the light-weight nature of the cable.

The description of this specification described above is for illustration, and those skilled in the art to which embodiments of this specification pertain will be able to understand that embodiments of the present disclosure may be easily modified in different specific forms without changing the technical spirit or essential features described in this specification. Accordingly, it should be understood that the embodiments described above are illustrative and not restrictive in all respects. For example, each component described as a single type may be implemented in a dispersed manner, and likewise, the components described as dispersed may also be implemented in a coupled form.

The scope of this specification is determined by the appended claims, and all changes or modifications derived from the meaning and scope of the claims and their equivalents should be construed as being included in the scope of this specification.

**Claims**

1. A resin composition for shielding electromagnetic waves, the resin composition, based on a total weight of the resin composition, comprising:

   20 to 80 wt% of thermoplastic resin;
   1 to 50 wt% of a conductive filler, wherein the conductive filler comprises a material selected from the group consisting of carbon fiber, carbon nanotube, carbon black, nd a mixture of two or more among the above components; and
   0.1 to 30 wt% of an additive.

2. The resin composition of claim 1, wherein the thermoplastic resin comprises a resin selected from the group consisting of thermoplastic polyurethane, thermoplastic polyester elastomer, polyamide, polyethylene, ethylene vinyl acetate copolymer, ethylene butyl acrylate copolymer, ethylene ethyl acrylate copolymer, ethylene methyl acrylate copolymer, thermoplastic crosslinked elastomer, polypropylene, polyvinyl chloride, ethylene propylene rubber, ethylene propylene diene monomer rubber, silicone rubber, fluorine-based resin, polyolefin elastomer, and combinations thereof.

3. The resin composition of claim 1, wherein the conductive filler comprises the carbon fiber, and wherein an average length of the carbon fiber is in a range of 1 to 10 mm.

4. The resin composition of claim 1, wherein the conductive filler comprises the carbon black, and wherein the carbon black comprises a first carbon black having an average particle diameter in a range of 1 to 50 nm and a second carbon black having an average particle diameter in a range of 50 to 500 nm.

5. The resin composition of claim 4, wherein a weight ratio of the first carbon black and the second carbon black is 1:0.5~2.

6. The resin composition of claim 1, further comprising 0.1 to 5 wt% of metal-based powder.

7. The resin composition of claim 6, wherein the metal-based powder comprises a material selected from the group consisting of tin (Sn), copper (Cu), aluminum (Al), barium titanate ($BaTiO_3$), and combinations thereof.

8. A cable for shielding electromagnetic waves, the cable comprising:

   a conductor;
   a cable sheath; and
   a conductive polymer layer interposed between the conductor and the cable sheath,
   wherein the conductive polymer layer comprises a resin composition, and wherein, based on a total weight of the resin composition, the resin composition comprises:

   20 to 80 wt% of thermoplastic resin;
   1 to 50 wt% of a conductive filler, wherein the conductive filler comprises carbon fiber, carbon nanotube, carbon black, or a combination thereof; and
   0.1 to 30 wt% of an additive.

9. The cable of claim 8, wherein an average thickness of the conductive polymer layer is in a range of 0.2 to 2.0 mm.

10. The cable of claim 8, further comprising a first olefin layer on a surface of the conductor, wherein the conductive polymer layer is on a surface of the first olefin layer.

11. The cable of claim 10, further comprising a second olefin layer on a surface of the conductive polymer layer.

12. The cable of claim 11, further comprising a conductive tape interposed between the conductive polymer layer and the second olefin layer.

13. The cable of claim 12, wherein the conductive tape comprises a composite magnetic tape, an aluminum mylar tape, or a copper tape.

## FIG. 1A

## FIG. 1B

# FIG. 2A

# FIG. 2B

# FIG. 3

<EXAMPLE 1>

<COMPARATIVE EXAMPLE 1>

<COMPARATIVE EXAMPLE 2>

FIG. 4

<EXAMPLE 1>

30mm

<EXAMPLE 2>

33mm

Europäisches
Patentamt

European
Patent Office

Office européen
des brevets

# EUROPEAN SEARCH REPORT

Application Number

**EP 23 15 2109**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/216646 A1 (NOGUCHI TORU [JP] ET AL) 11 September 2008 (2008-09-11) | 1-7 | INV. H01B1/24 |
| A | * claim 1; examples 1-4; table 1 * | 8-13 | C08K7/02 C08L23/14 |
| X | WO 2022/158599 A1 (SEKISUI TECHNO MOLDING CO LTD [JP]) 28 July 2022 (2022-07-28) | 1-5 | H01B7/28 H01B9/02 |
| A | * paragraph [0023] – paragraph [0023]; examples 1-12 * | 6-13 | H05K9/00 |
| X | US 2021/269617 A1 (CHOI GI DAE [KR] ET AL) 2 September 2021 (2021-09-02) | 1-3,6,7 | ADD. C08K3/08 H01L23/552 |
| A | * claims 1-14; examples 1-6; table 1 * | 4,5,8-13 | |
| X | KR 2020 0085506 A (HYUNDAI MOTOR CO LTD [KR]; HANWHA COMPOUND CORP [KR] ET AL.) 15 July 2020 (2020-07-15) | 1-5 | |
| A | * claims 1-9; examples 1-4; tables 1-2 * | 6-13 | |
| X | US 2013/177765 A1 (LIM YOON SOOK [KR] ET AL) 11 July 2013 (2013-07-11) | 1-3,6,7 | |
| A | * claims 1-19; example 8; table 1 * | 4,5,8-13 | TECHNICAL FIELDS SEARCHED (IPC) |
| X | JP 2014 133842 A (YAZAKI CORP) 24 July 2014 (2014-07-24) | 1-3,8-13 | H01B H05B |
| A | * paragraph [0002] – paragraph [0003] * * paragraph [0007] – paragraph [0009]; examples 1-36 * | 4-7 | C08K C08L H05K H01L |
| X | WO 2022/102904 A1 (HANWHA COMPOUND CORP [KR]; YURA CO LTD [KR]) 19 May 2022 (2022-05-19) | 1-3,8-13 | |
| A | * paragraph [0084] – paragraph [0086]; claims 1-11; examples 1-8; table 1 * | 4-7 | |
| X | WO 2017/100614 A1 (GENERAL CABLE TECH CORP [US]) 15 June 2017 (2017-06-15) * claims 1-20; examples 5-7; tables 1-2 * | 1-13 | |

The present search report has been drawn up for all claims

| Place of search | Date of completion of the search | Examiner |
|---|---|---|
| Munich | 4 August 2023 | Marsitzky, Dirk |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

......................................................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 15 2109

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2023

| Patent document cited in search report | Publication date | Patent family member(s) | Publication date |
|---|---|---|---|
| US 2008216646 A1 | 11-09-2008 | JP 4229967 B2 | 25-02-2009 |
| | | JP 2008223780 A | 25-09-2008 |
| | | US 2008216646 A1 | 11-09-2008 |
| WO 2022158599 A1 | 28-07-2022 | JP 7127234 B1 | 29-08-2022 |
| | | JP 2022164711 A | 27-10-2022 |
| | | JP WO2022158599 A1 | 28-07-2022 |
| | | WO 2022158599 A1 | 28-07-2022 |
| | | WO 2022158600 A1 | 28-07-2022 |
| US 2021269617 A1 | 02-09-2021 | CN 112424273 A | 26-02-2021 |
| | | EP 3808803 A1 | 21-04-2021 |
| | | JP 7055931 B2 | 18-04-2022 |
| | | JP 2021532214 A | 25-11-2021 |
| | | KR 102125262 B1 | 22-06-2020 |
| | | US 2021269617 A1 | 02-09-2021 |
| | | WO 2020145500 A1 | 16-07-2020 |
| KR 20200085506 A | 15-07-2020 | NONE | |
| US 2013177765 A1 | 11-07-2013 | CN 102985492 A | 20-03-2013 |
| | | KR 20120034538 A | 12-04-2012 |
| | | US 2013177765 A1 | 11-07-2013 |
| JP 2014133842 A | 24-07-2014 | NONE | |
| WO 2022102904 A1 | 19-05-2022 | KR 20220065176 A | 20-05-2022 |
| | | WO 2022102904 A1 | 19-05-2022 |
| WO 2017100614 A1 | 15-06-2017 | BR 112018010744 A2 | 28-08-2018 |
| | | CA 3004917 A1 | 15-06-2017 |
| | | US 2017169920 A1 | 15-06-2017 |
| | | WO 2017100614 A1 | 15-06-2017 |

EPO FORM P0459

For more details about this annex : see Official Journal of the European Patent Office, No. 12/82